# EUROPÄISCHE PATENTSCHRIFT

(11) **EP 2 721 422 B1**
(45) Veröffentlichungstag und Bekanntmachung des Hinweises auf die Patenterteilung: **24.02.2021**
(21) Anmeldenummer: 12719672.3
(22) Anmeldetag: 03.05.2012
(51) Int. Cl.: G01R 23/16, G01R 31/28, G01R 27/32, G01R 23/18

(54) **VERFAHREN UND MESSGERÄT ZUR UNTERDRÜCKUNG VON STÖRSIGNALEN**
METHOD AND MEASURING DEVICE FOR SUPPRESSING INTERFERING SIGNALS
PROCÉDÉ ET APPAREIL DE MESURE POUR LA SUPPRESSION DE SIGNAUX PARASITES

(30) Priorität: 14.06.2011 DE 102011104139; 13.07.2011 DE 102011079086
(43) Veröffentlichungstag der Anmeldung: 23.04.2014
(73) Patentinhaber: Rohde & Schwarz GmbH & Co. KG, 81671 München (DE)
(72) Erfinder: FELDHAUS, Gregor, 81669 München (DE); ROTH, Alexander, 84405 Dorfen (DE)
(74) Vertreter: Körfer, Thomas
(86) Internationale Anmeldenummer: PCT/EP2012/058063
(87) Internationale Veröffentlichungsnummer: WO 2012/171713

(56) Entgegenhaltungen:
- EP-A2- 0 841 569
- EP-A2- 1 884 876
- WO-A1-98/59252
- US-A- 4 791 577
- US-A- 5 629 703
- US-A1- 2007 229 056

## Beschreibung

Die Erfindung betrifft ein Verfahren zur Unterdrückung von Störsignalen in Messsignalen, vorzugsweise von schmalbandigen Störsignalen in Spektrumanalysatoren, und ein entsprechendes Messgerät.

In Spektrumanalysatoren werden Messsignale üblicherweise in eine Zwischenfrequenz umgesetzt und anschließend digitalisiert. Analoge Bauelemente des Spektrumanalysators können dabei ein nichtlineares Verhalten zeigen. Insbesondere die Analog-Digital-Wandler, welche zur Digitalisierung der Messsignale im Zwischenfrequenz-Bereich eingesetzt werden, weisen häufig ein nichtlineares Verhalten auf. Hierdurch können Störsignale, insbesondere schmalbandige Störsignale, entstehen. So zeigt die DE 10 2004 020 278 A1 einen herkömmlichen Spektrumanalysator ohne eine solche Störsignalunterdrückung.

In der US 4,791,577 A wird ein Spektrum-Analysator offenbart, in dem Störsignale in einem Messsignal unterdrückt werden. Hierzu wird ein zu messendes Signal mit einem ersten lokalen Oszillator zu einem ersten Zwischenfrequenzsignal gemischt und digitalisiert. Aus diesem ersten digitalisierten Zwischenfrequenzsignal wird mittels diskreter Fouriertransformation ein erstes Frequenzspektrum ermittelt. Gleichzeitig wird das zu messende Signal mit einem zweiten lokalen Oszillator mit unterschiedlicher Frequenz zu einem zweiten Zwischenfrequenzsignal gemischt, digitalisiert und durch eine diskrete Fouriertransformation zu einem zweiten Frequenzspektrum gewandelt. Das zweite Frequenzspektrum wird durch ein Schieberegister so angepasst, dass die Mittenfrequenzen des ersten Frequenzspektrums und des zweiten Frequenzspektrums in ihrer Mittenfrequenz übereinstimmen. Nun werden beide Frequenzspektren miteinander verglichen. Der Vergleich der Frequenzspektren erfolgt paarweise für jeden Wert. Mit dem Ergebnis wird ein Multiplexer gesteuert. Dieser Multiplexer verbindet im Fall eines störungsfreien Messsignals den Ausgang des ersten Fouriertransformators mit dem Ausgang des Messgeräts. Tritt eine Störung auf, verbindet der Multiplexer ein Nullsignal mit dem Ausgang.

Die WO 98/59252 A1 offenbart einen Spektrumanalysator, der ein Hochfrequenzsignal mit einer Reihe unterschiedlicher Frequenzeinstellungen in ein Zwischenfrequenzsignal wandelt. Der Spektrumanalysator führt eine Frequenzanalyse eines jeden Zwischenfrequenzsignals durch, um daraus ein Leistungsspektrum zu erzeugen. Diese Leistungsspektren werden zu einem zusammengesetzten Leistungsspektrum kombiniert. Durch das Zusammensetzen der Leistungsspektren ergibt sich ein Mittelwert, wodurch Störsignale reduziert werden können. Das zusammengesetzte Leistungsspektrum wird durch den Spektrumanalysator bearbeitet, um das Leistungsspektrum des empfangenen Radiofrequenzsignals darzustellen.

Die EP 0841 569 A2 offenbart einen Spektrum Analysator. In diesem Spektrum Analysator wird ein Eingangssignal mit einem Mischer in mehrere unterschiedliche Zwischenfrequenzsignal umgesetzt. Hierzu wird ein lokaler Oszillator entsprechend abgestimmt. Diese Zwischenfrequenzsignale werden digitalisiert. Für jedes digitalisierte Zwischenfrequenzsignal wird eine Frequenzanalyse durchgeführt. Der Frequenzversatz zwischen den digitalisierten Zwischenfrequenzsignalen wird ausgeglichen und die resultierenden digitalisierten Zwischenfrequenzsignale zu einem Gesamtspektrum kombiniert. Durch dieses Vorgehen werden Störsignale in Messsignalen gedämpft.

Die US 5,629,703 A offenbart einen Spektrumanalysator mit einem Verfahren zur Reduzierung einer Amplitude von Harmonischen und Störsignalen. Im ersten Schritt des Verfahrens wird ein Eingangssignal im Zeitbereich digitalisiert und in einen Frequenzbereich-Datensatz transformiert. In einem zweiten Schritt wird der lokaler Oszillator, der das Mischsignal für den Mischer erzeugt, in seiner Frequenz verändert. Es wird ein zusätzlicher Zeitbereichsdatensatz erfasst, digitalisiert, transformiert und gespeichert. Dieser zusätzliche Zeitbereichsdatensatz ist in seiner Mittenfrequenz verschoben. Der in der Mittenfrequenz verschobene Datensatz wird bezüglich des ersten Datensatzes mathematisch so verschoben, dass die Mittenfrequenzen beider Datensätze übereinstimmen. Nun werden die Datensätze kombiniert, um einen Frequenzbereich-Datensatz mit verringerten Oberwellen- und Störsignalamplituden zu erzeugen.

Die US 2007/0229056 A1 offenbart ein Lokaloszillator-Diversity-System für einen Spektrumanalysator. Der Spektrum Analysator mischt ein Eingangssignal mit einem ersten Lokaloszillator-Signal, dessen Frequenz festgelegt ist. Das entstehende Signal wird erfasst und aufgezeichnet. Dieses Signal enthält einen ersten Satz von Störsignalen. Das Eingangssignal wird mit einem zweiten Lokaloszillator-Signal entsprechend abgetastet, wodurch ein zweites aufgezeichnetes Signal entsteht, das einen zweiten Satz von Störsignalen enthält. Dabei ist mindestens ein Störsignal in dem ersten Satz von Störsignalen auf einer Frequenz vorhanden, das auf derselben Frequenz im zweiten Satz vom Störsignalen und umgekehrt nicht enthalten ist. Durch eine Auswerteeinheit wird bei einer bestimmten Frequenz der Signalwert aus den beiden aufgezeichneten Signalen ausgewählt, der den niedrigsten Signallevel enthält. Dieser Wert wird zur Anzeige gebracht.

Die EP 1884 876 A2 zeigt ein Verfahren zur Umwandlung eines Signals vom Zeitbereich in den Frequenzbereich mit Hilfe einer Frequenzverschiebung. Ein Eingangssignal wird mit einem ersten Frequenzversatz digitalisiert. Dieses im Zeitbereich befindliche Signal wird nun in den Frequenzbereich konvertiert. Nun wird ein weiteres Mal mit einer zweiten Frequenzverschiebung abgetastet. Dieses Signal wird ebenfalls in den Frequenzbereich konvertiert. Die beiden Datensätze im Frequenzbereich werden kombiniert, um kombinierte Frequenzbereichsdaten zu erzeugen. Die kombinierten Frequenzbereichsdaten werden zur weiteren Verarbeitung durch ein Test- und Messsystem bereitgestellt.

Der Erfindung liegt die Aufgabe zugrunde, ein Verfahren zur Unterdrückung eines Störsignals in einem Signal und ein entsprechendes Messgerät zu schaffen.

Die Aufgabe wird erfindungsgemäß für das Verfahren durch die Merkmale des unabhängigen Anspruchs 1 und für das Messgerät durch die Merkmale des unabhängigen Anspruchs 9 gelöst. Vorteilhafte Weiterbildungen sind Gegenstand der hierauf rückbezogenen Unteransprüche.

Ein erfindungsgemäßes Messgerät zur Unterdrückung eines Störsignals beinhaltet einen Mischer, einen Analog-Digital-Wandler, und eine Ersetzungseinrichtung. Der Mischer ist dazu ausgebildet, ein erstes Signal mit einer ersten Zwischenfrequenz zu mischen und ein zweites Signal mit einer zweiten Zwischenfrequenz zu mischen. Der Analog-Digital-Wandler ist dazu ausgebildet, das mit der ersten Zwischenfrequenz gemischte erste Signal zu einem ersten Messsignal zu digitalisieren und das mit der zweiten Zwischenfrequenz gemischte zweite Signal zu einem zweiten Messsignal zu digitalisieren. Die Ersetzungseinrichtung ist dazu ausgebildet, das erste Messsignal und das zweite Messsignal unter Entfernung von Störsignal-Spitzenwertbereichen, welche dem Störsignal entsprechen, zu einem Gesamtmesssignal zu kombinieren. Es wird so eine gründliche Entfernung von Störsignalanteilen aus dem Messsignal erreicht, während das Messsignal nicht verfälscht wird. Vorteilhafterweise werden hierzu Spitzenwertbereiche detektiert und ermittelt, ob es sich dabei um die Störsignal-Spitzenwertbereiche handelt.

Vorzugsweise ist eine Normierungseinrichtung vorhanden. Die Normierungseinrichtung ist dazu ausgebildet, zumindest das erste Messsignal und/oder das zweite Messsignal in seiner Frequenz derart zu verschieben, dass sie eine gemeinsame Mittenfrequenz aufweisen.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes beispielhaftes Messsignal;
- Fig. 2: ein zweites beispielhaftes Messsignal;
- Fig. 3: das erste beispielhafte Messsignal und das zweite beispielhafte Messsignal in einer gemeinsamen Darstellung;
- Fig. 4: ein erstes beispielhaftes Gesamtmesssignal;
- Fig. 5: ein zweites beispielhaftes Gesamtmesssignal;
- Fig. 6: eine beispielhafte Darstellung eines zu erwartenden Messfehlers;
- Fig. 7: ein Flussdiagramm eines ersten Ausführungsbeispiels des erfindungsgemäßen Verfahrens;
- Fig. 8: ein drittes beispielhaftes Messsignal;
- Fig. 9: ein Flussdiagramm eines zweiten Ausführungsbeispiels des erfindungsgemäßen Verfahrens, und
- Fig. 10: ein Blockschaltbild eines Ausführungsbeispiels des erfindungsgemäßen Messgeräts.

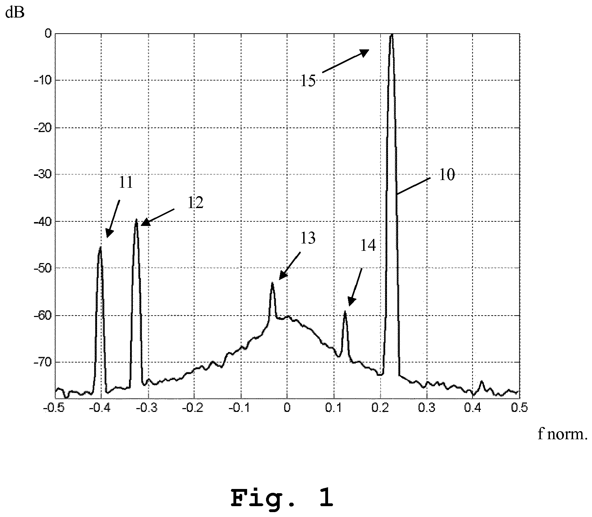

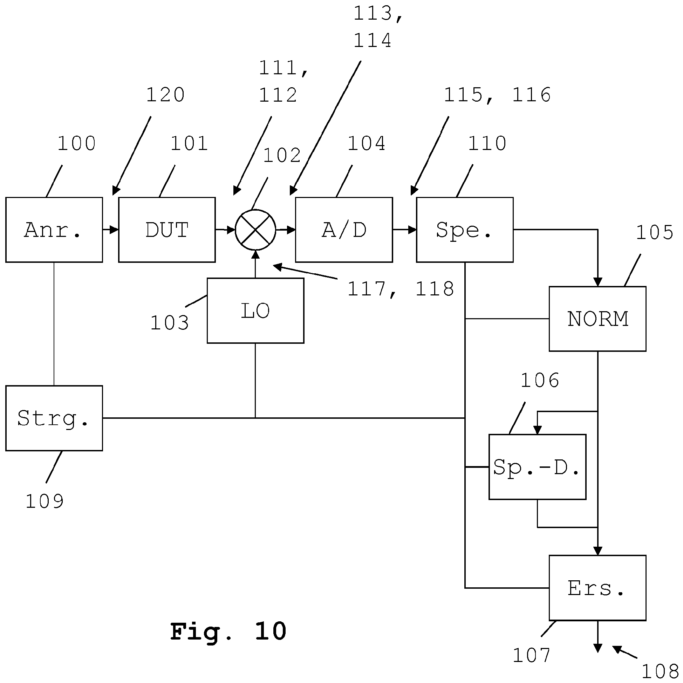

Zunächst wird anhand von Fig. 1 - 9 die Funktionsweise des erfindungsgemäßen Verfahrens gezeigt. Anschließend wird anhand von Fig. 10 auf den Aufbau und die Funktionsweise des erfindungsgemäßen Messgeräts eingegangen. Identische Elemente wurden in ähnlichen Abbildungen zum Teil nicht wiederholt dargestellt und beschrieben.

In Fig. 1 ist ein erstes beispielhaftes Messsignal 10 im Frequenzbereich dargestellt. Die Frequenz ist dabei auf einer normierten x-Achse angezeigt. Das Messsignal 10 wurde dabei durch Mischung eines Signals mit einem ersten Zwischenfrequenzsignal und anschließende Digitalisierung erzeugt. Das Messsignal 10 weist dabei eine Vielzahl von Spitzenwertbereichen 11 - 15 auf. Diese Spitzenwertbereiche 11 - 15 können dabei entweder Störsignal-Spitzenwertbereiche sein, verursacht z.B. durch nichtlineare Komponenten des Messgeräts, oder Nutzsignal-Spitzenwertbereiche des angeschlossenen zu vermessenden Objekts. Eine Unterscheidung ist anhand dieses einen Messsignals 10 nicht möglich.

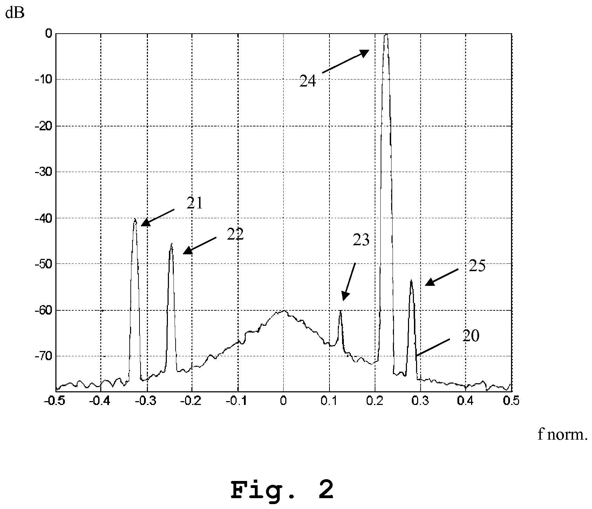

Fig. 2 zeigt ein zweites beispielhaftes Messsignal 20. Das Messsignal 20 ist ebenfalls im Frequenzbereich dargestellt. Auch hier ist die Frequenz normiert. Auch dieses Messsignal 20 ist durch Mischung eines Eingangssignals mit einem zweiten Zwischenfrequenzsignal und anschließender Abtastung entstanden. Auch in diesem zweiten Messsignal 20 befindet sich eine Vielzahl von Spitzenwertbereichen 21 - 25. Diese Spitzenwertbereiche 21 - 25 gehen entweder auf Störsignale oder auf Nutzsignale des vermessenen Messobjekts zurück. Auch hier ist eine Unterscheidung anhand des einen Messsignals 20 nicht möglich.

Das zweite Zwischenfrequenzsignal weist eine unterschiedliche Frequenz auf als das erste Zwischenfrequenzsignal aus Fig. 1. Dies führt dazu, dass Störsignalanteile, welche z.B. durch nichtlineare Komponenten des Messgeräts entstanden sind, auf einer unterschiedlichen Frequenz zu liegen kommen, als dies bei Fig. 1 der Fall ist. D.h. Spitzenwertbereiche 12, 14, 15 aus Fig. 1, welche einem Spitzenwertbereich 21, 23, 24 aus Fig. 2 entsprechen, sind Nutzsignal-Spitzenwertbereiche.

Spitzenwertbereiche 11, 13 und 21, 25, welche keine Entsprechung finden, sind Störsignal-Spitzenwertbereiche.

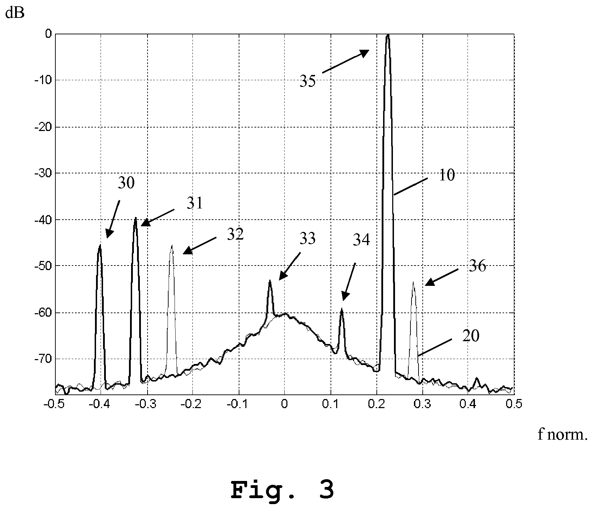

Dies ist in Fig. 3 deutlich erkennbar. In Fig. 3 sind das erste Messsignal 10 und das zweite Messsignal 20 dargestellt. Zusätzlich sind Spitzenwerte 30 - 36 beider Signale 10 - 20 dargestellt. Der Spitzenwertbereich 31 entspricht dem Spitzenwertbereich 12 aus Fig. 1 und 21 aus Fig. 2. Es handelt sich somit um ein Nutzsignal-Spitzenwertbereiche. Gleiches gilt für die Spitzenwertbereiche 34 und 35, welche den Spitzenwertbereichen 14, 23 und 15, 24 entsprechen. Die Spitzenwertbereiche 30, 32, 33 und 36 liegen jedoch nicht in beiden Messsignalen 10, 20 vor. D.h. es handelt sich um Störsignal-Spitzenwertbereiche. Diese Störsignale sind zu unterdrücken.

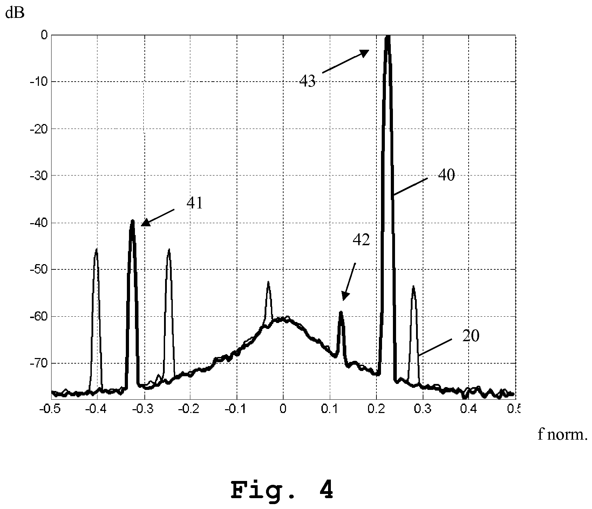

Werden die anhand von Fig. 3 ermittelten Störsignale unterdrückt, so ergibt sich das in Fig. 4 fett dargestellte Gesamtmesssignal 40. Es beinhaltet nun lediglich die Spitzenwertbereiche 41 - 43, welche auf Nutzsignale des Messobjekts zurückgehen.

Die Signale aus Fig. 1 - 4 weisen ein sehr geringes Rauschen auf. Dies liegt daran, dass es sich um gemittelte Signale handelt. D.h. das Messsignal 10 aus Fig. 1 wie auch das Messsignal 20 aus Fig. 2 entsprechen jeweils einer Mittelung über beispielsweise 100 Messungen mit identischer Zwischenfrequenz.

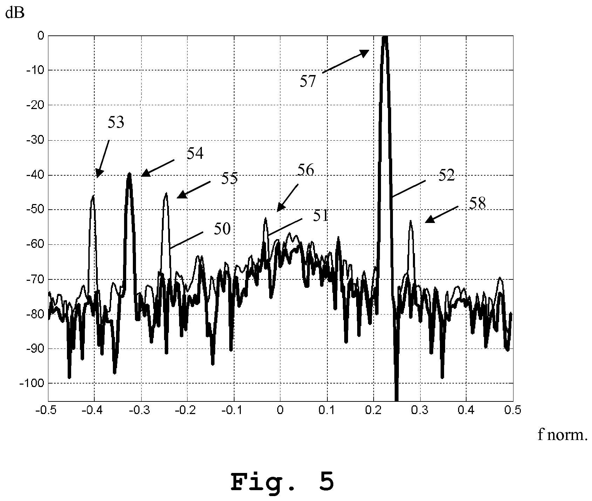

In Fig. 5 sind entsprechende Signale ohne Mittelung dargestellt. Ein erstes Messsignal 50 ist durch Mischung eines Eingangssignals mit einer ersten Zwischenfrequenz und anschließender Digitalisierung entstanden. Ein zweites Messsignal 51 ist durch Mischung des Eingangssignals mit einer zweiten Zwischenfrequenz und anschließende Digitalisierung entstanden. Beide Signale 50 und 51 sind hier mit normierter Frequenz dargestellt. In Summe ergeben sich die Spitzenwertbereiche 53 - 58. Auch hier ist erkennbar, dass nicht sämtliche Spitzenwertbereiche 53 - 58 in beiden Signalen 50, 51 vorkommen. Lediglich die Spitzenwertbereiche 54 und 57 kommen in beiden Signalen 50, 51 vor. D.h. die Spitzenwertbereiche 54 und 57 sind Nutzsignal-Spitzenwertbereiche. Die übrigen Spitzenwertbereiche 53, 55, 56 und 58 sind Störsignal-Spitzenwertbereiche.

In Fig. 5 ist ein kombiniertes Gesamtmesssignal 52 dargestellt. Es beinhaltet lediglich die Nutzsignal-Spitzenwertbereiche 54 und 57. Im Übrigen entspricht das Gesamtmesssignal 52 dem Minimum aus den Signalen 50 und 51. Dieses Vorgehen erzeugt jedoch einen systematischen Fehler. D.h. der Rauschpegel wird durch diese Minimumbildung systematisch zu niedrig eingeschätzt. Dies ist insbesondere bei Verzicht auf eine Mittelung und damit auf eine Rauschunterdrückung erkennbar.

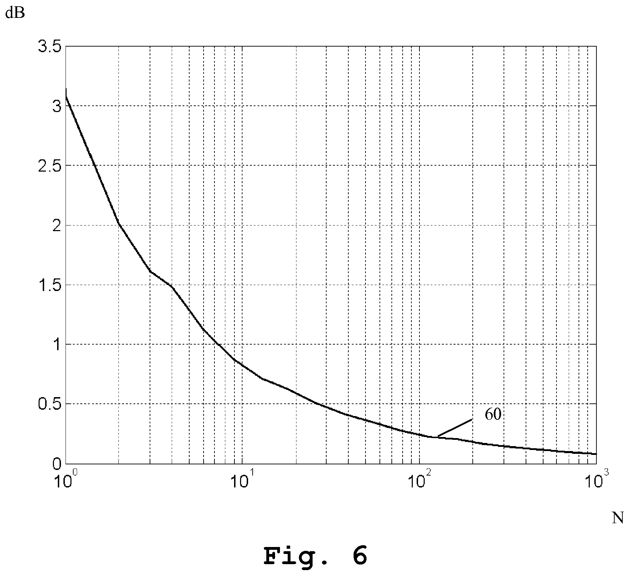

So zeigt Fig. 6 die Größe des systemischen Fehlers 60 in Abhängigkeit von der Anzahl der Messungen N, über welche jeweils gemittelt wurde. Erkennbar ist hier, dass bei Verzicht auf eine Mittelung ein Fehler von über 3 dB entsteht. Bei den anhand von Fig. 1 und Fig. 2 gezeigten Signalen mit einer Mittelung über 100 Einzelmessungen ergibt sich ein Fehler von unter 0,5 dB.

Um diesen Mittelungsfehler zu vermeiden, können alternativ die Werte eines der beiden Messsignale herangezogen werden. Auch eine Amplituden-Mittelung dieser beiden Messsignale ist möglich. Hierdurch entsteht jedoch eine Verringerung der Varianz gegenüber einem einzelnen Messsignal. Auch eine Mittelung der Leistung der beiden Messsignale ist denkbar.

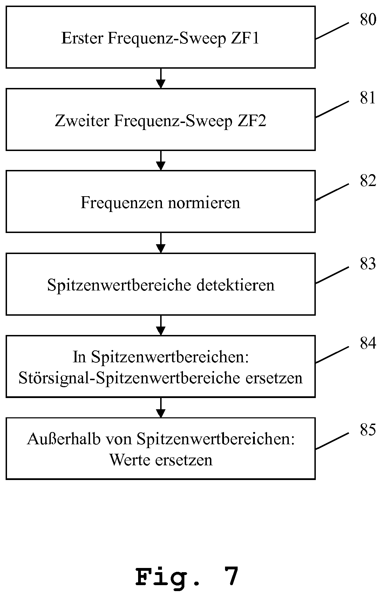

Fig. 7 zeigt ein Flussdiagramm eines ersten Ausführungsbeispiels des erfindungsgemäßen Verfahrens. In einem ersten Schritt 80 wird eine erste Messung durchgeführt. D.h. das Messobjekt wird mit einem ersten Frequenzverlauf beaufschlagt. Das resultierende Signal wird mit einer Zwischenfrequenz gemischt und das daraus resultierende Signal zu einem ersten Messsignal abgetastet.

In einem zweiten Schritt 81 wird das Messobjekt erneut mit dem identischen Frequenzverlauf beaufschlagt. Das resultierende Signal wird mit einem zweiten Zwischenfrequenzsignal gemischt und zu einem zweiten Messsignal abgetastet. In einem dritten optionalen aber bevorzugten Schritt 82 werden die Frequenzen des ersten Messsignals und/oder des zweiten Messsignals normiert. Wichtig ist hier, dass die resultierenden Messsignale eine identische Mittenfrequenz aufweisen.

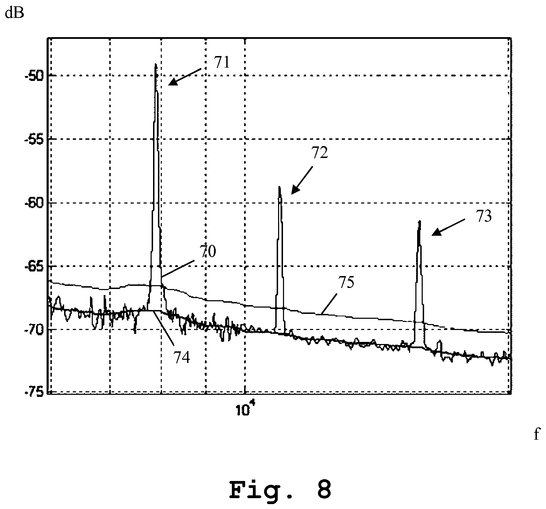

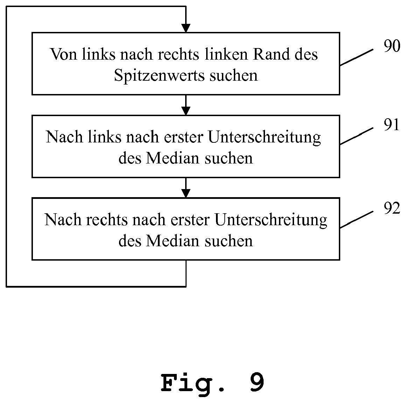

In einem vierten Schritt 83 werden die Spitzenwertbereiche der beiden Messsignale detektiert. Hierauf wird anhand der Fig. 8 und Fig. 9 näher eingegangen. Anschließend werden in einem fünften Schritt 84 in den Spitzenwertbereichen Störsignal-Spitzenwertbereiche ersetzt. D.h. es wird ermittelt, ob es sich bei den im vierten Schritt 83 ermittelten Spitzenwertbereichen um Störsignal-Spitzenwertbereiche handelt. Dies ist der Fall, wenn die Spitzenwertbereiche lediglich in einem der beiden Messsignale vorliegen. Liegen die Spitzenwertbereiche dagegen in beiden Messsignalen vor, so handelt es sich nicht um Störsignal-Spitzenwertbereiche, sondern um Nutzsignal-Spitzenwertbereiche, welche auf Nutzsignale des Messobjekts zurückgehen. In den ermittelten Störsignal-Spitzenwertbereichen wird das Gesamtmesssignal durch das Messsignal gebildet, welches in diesem Bereich keinen Spitzenwertbereich aufweist.

In einem abschließenden sechsten Schritt 85 werden außerhalb der ermittelten Spitzenwertbereiche die Werte des gesamten Messsignals durch die Werte der beiden Messsignale gebildet. Hierzu kann beispielsweise der Mittelwert der Amplituden der beiden Messsignale eingesetzt werden. Alternativ kann auch die mittlere Leistung der beiden Messsignale genutzt werden. Alternativ kann auch stets eines der beiden Messsignale eingesetzt werden. Diese letzte Option erhält als einzige die Statistik des Rauschens aufrecht.

Das resultierende Gesamtmesssignal beinhaltet somit außerhalb der Spitzenwertbereiche ein Signal, welches entweder einem der Messsignale entspricht oder durch Zusammenführung der beiden Messsignale entstanden ist und im Bereich der Störsignal-Spitzenwertbereiche ein Signal, welches einem der beiden Messsignale entspricht. Störsignale, welche z.B. durch das nichtlineare Verhalten von Bauteilen des Messgeräts entstanden sind, sind nicht länger Teil des Gesamtmesssignals. Spitzenwerte, welche auf das Nutzsignal des Messobjekts zurückgehen, sind jedoch nach wie vor in dem Gesamtmesssignal vorhanden.

In Fig. 8 ist ein drittes beispielhaftes Messsignal 70 dargestellt. Es kann sich dabei um das erste Messsignal oder das zweite Messsignal handeln. Es weist die Spitzenwertbereiche 71 - 73 auf. Um die Spitzenwertbereiche 71 - 73 zu detektieren, wird das Messsignal 70 mit einer Schwellwertkurve 75 verglichen.

Die Schwellwertkurve 75 ist dabei eine Median-Kurve 74, welche derart nach oben verschoben ist, dass maximal 1% der Rauschwerte des Messsignals die Schwellwertkurve 75 übersteigen. Alternativ kann auch ein abweichender Prozentsatz, beispielsweise 2% oder 5% eingesetzt werden.

Bei einem sehr einfachen Vorgehen könnten sämtliche Signalanteile des Messsignals 70, welche die Schwellwertkurve 75 übersteigen, als Spitzenwertbereich 71-73 betrachtet werden. Dies hätte jedoch systematische Fehler zur Folge. So wäre jeweils direkt vor und nach den Spitzenwertbereichen ein Wert in Höhe der Schwellwertkurve 75 vorhanden. Dies würde die Signalstatistik signifikant beeinflussen. Um diesen Fehler zu vermeiden, wird zur Detektion der Spitzenwertbereiche 71 - 73 das in Fig. 9 dargestellte Verfahren eingesetzt.

So wird in einem ersten Schritt 90 von links nach rechts der linke Rand des Spitzenwertbereichs gesucht. Ein solcher wird durch ein Überschreiten der Schwellwertkurve 75 durch den Messwert 70 erkannt. Ausgehend von diesem ermittelten Punkt wird von rechts nach links nach dem ersten Unterschreiten einer Median-Kurve 74 des Messsignals 70 gesucht.

Die Median-Kurve 74 entspricht dabei einer Filterung des Spektrums mit einem Median-Filter, d.h. die Spitzenwerte werden verworfen. Dieser Punkt wird als Beginn des Spitzenwertbereichs angesehen. Ausgehend von diesem Punkt wird von links nach rechts von einem ersten Unterschreiten der Median-Kurve 74 durch das Messsignal 70 gesucht. Dieser Punkt wird als Ende des Spitzenwertbereichs detektiert.

In Fig. 10 ist ein Ausführungsbeispiel des erfindungsgemäßen Messgeräts dargestellt. Eine Anregungseinrichtung 100 ist mit einer Steuereinrichtung 109 verbunden. Die Anregungseinrichtung 100 ist weiterhin mit einem Signaleingang eines Messobjekts 101 verbunden. Ein Signalausgang des Messobjekts 101 ist mit einem Mischer 102 verbunden. Der Mischer 102 ist weiterhin mit einem Lokaloszillator 103 verbunden, welcher erneut mit der Steuereinrichtung 109 verbunden ist. Ein Signalausgang des Mischers 102 ist mit einem Analog-Digital-Wandler 104 verbunden. Der Analog-Digital-Wandler 104 ist mit einer Speichereinrichtung 110 verbunden, welche wiederum mit einer bevorzugten Normierungseinrichtung 105 verbunden ist. Die Speichereinrichtung 110 und die Normierungseinrichtung 105 sind ebenfalls mit der Steuereinrichtung 109 verbunden. Die Normierungseinrichtung 105 ist weiterhin mit einem Spitzenwert-Detektor 106 und einer Ersetzungseinrichtung 107 verbunden. Auch der Spitzenwert-Detektor 106 ist mit der Ersetzungseinrichtung 107 verbunden. Sowohl der Spitzenwert-Detektor 106 wie auch die Ersetzungseinrichtung 107 sind ebenfalls mit der Steuereinrichtung 109 verbunden.

Die Steuereinrichtung 109 steuert die Anregungseinrichtung 100 derart, dass diese ein Anregungssignal 120 erzeugt und damit das Messobjekt 101 beaufschlagt. Bei dem Anregungssignal 120 handelt es sich hier um einen Frequenz-Sweep. Auch abweichende Anregungssignale sind denkbar. Das Messobjekt 101 verarbeitet das Anregungssignal 120 und gibt ein erstes Signal 111 aus. Dieses wird an den Mischer 102 übertragen. Der Mischer 102 mischt das erste Signal mit einer ersten Zwischenfrequenz 117, welche von dem Lokaloszillator 103 erzeugt wird. Die Erzeugung der ersten Zwischenfrequenz 117 wird dabei ebenfalls von der Steuereinrichtung 109 gesteuert. Das resultierende Signal 113 wird von dem Analog-Digital-Wandler 104 abgetastet und digitalisiert und so zu einem ersten Messsignal 115 verarbeitet, welches digital vorliegt. Dieses resultierende erste Messsignal 115 wird der Speichereinrichtung 110 zugeführt und von dieser gespeichert.

In einem zweiten Durchlauf regt die Anregungseinrichtung 100, gesteuert durch die Steuereinrichtung 109, das Messobjekt 101 mit einem identischen Anregungssignal 120 an. Das Messobjekt 101 verarbeitet das Anregungssignal 120 und erzeugt ein zu dem ersten Signal 111 weitgehend identisches zweites Signal 112. Das erste Signal 111 und das zweite Signal 112 unterscheiden sich lediglich in ihren Störkomponenten. D.h. der Rauschanteil unterscheidet sich. Dieses zweite Signal 112 wird von dem Mischer 102 mit einer zweiten Zwischenfrequenz 118, welche von dem Lokaloszillator 103 gesteuert von der Steuereinrichtung 109 erzeugt wird, gemischt. Das resultierende Signal 114 wird dem Analog-Digital-Wandler 104 zugeführt, welcher es zu einem zweiten Messsignal 116 digitalisiert. Auch dieses zweite Messsignal 116 wird der Speichereinrichtung 110 zugeführt und von dieser gespeichert.

Die erste Zwischenfrequenz 117 und die zweite Zwischenfrequenz 118 unterscheiden sich dabei. Hieraus folgt, dass das erste Messsignal 115 und das zweite Messsignal 116 einen Frequenzversatz aufweisen. Nutzsignalanteile, d.h. von dem Messobjekt 101 erzeugte Anteile in den beiden Messsignalen 115, 116, liegen verschoben um diesen Frequenzversatz vor. Störsignale, welche z.B. durch ein nichtlineares Verhalten des Analog-Digital-Wandlers 104 erzeugt wurden, weisen diesen Frequenzversatz nicht auf. Sie können einen beliebigen abweichenden Frequenzversatz aufweisen.

Sobald beide Durchläufe beendet sind, steuert die Steuereinrichtung 109 die Speichereinrichtung 110 derart, dass diese das erste Messsignal 115 und das zweite Messsignal 116 an die Normierungseinrichtung 105 weiterleitet. Das erste Messsignal 115 und das zweite Messsignal 116 werden von der Normierungseinrichtung 105 auf eine gemeinsame Mittenfrequenz normiert. D.h. im Frequenzbereich wird der Frequenzversatz des ersten Messsignals 115 und des zweiten Messsignals 116 durch Verschiebung zumindest eines der beiden Messsignale aufgehoben. Die resultierenden Signale weisen nun eine gemeinsame Mittenfrequenz auf.

Nutzsignalanteile liegen nun wieder übereinander. Störsignalanteile dagegen liegen lediglich in einem der beiden Signale vor. Die beiden resultierenden Messsignale werden, gesteuert von der Steuereinrichtung 109, dem Spitzenwert-Detektor 106 zugeführt. Dieser detektiert in jedem der Signale Spitzenwertbereiche. Die genaue Funktion des Spitzenwertdetektors 106 ist der Fig. 8 und Fig. 9 entnehmbar.

Gesteuert von der Steuereinrichtung 109 werden die normierten Messsignale weiterhin von der Normierungseinrichtung 105 an die Ersetzungseinrichtung 107 übertragen. Darüber hinaus stellt der Spitzenwertdetektor 106 der Ersetzungseinrichtung 107 die detektierten Spitzenwertbereiche zur Verfügung. Gesteuert von der Steuereinrichtung 109 erzeugt die ErsetzungsEinrichtung 107 nun ein gemeinsames Ausgangssignal 108. In Bereichen der beiden normierten Messsignale, in welchen bei einem der Signale ein Spitzenwertbereich detektiert wurde, bei dem anderen der Signale jedoch nicht, wird das Signale ohne Spitzenwertbereich in das gemeinsame Ausgangssignal übernommen. Bei dem in dem einen Signale detektierten Spitzenwertbereich handelt es sich lediglich um ein Störsignal-Spitzenwertbereich.

Wurde dagegen bei beiden Signalen ein Spitzenwertbereich detektiert, so handelt es sich um einen Nutzsignal-Spitzenwertbereich. In diesem Fall wie auch in sämtlichen Bereichen, in welchen bei beiden Signalen keine Spitzenwertbereiche detektiert wurden, werden beide Signale gemittelt und das resultierende Signal in das gemeinsame Ausgangssignal übernommen. Alternativ zu der Mittelung kann auch eine leistungsmäßige Mittelung durchgeführt werden. Als weitere Alternative kann auch stets das erste Messsignal oder stets das zweite Messsignal herangezogen werden.

Die Erfindung ist nicht auf das dargestellte Ausführungsbeispiel beschränkt. Wie bereits erwähnt, können unterschiedliche Störsignale kompensiert werden. Eine Einschränkung auf Störsignale, welche durch das nichtlineare Verhalten von Messgerätebauteilen, insbesondere des Analog-Digital-Wandlers, basieren, besteht nicht. Alle vorstehend beschriebenen Merkmale oder in den Figuren gezeigten Merkmale sind im Rahmen der Erfindung beliebig vorteilhaft miteinander kombinierbar.

## Patentansprüche

1. Verfahren zur Unterdrückung eines Störsignals,
wobei ein erstes Signal (111) mit einem ersten Zwischenfrequenzsignal (117) gemischt und das resultierende Signal (113) zu einem ersten Messsignal (10, 50, 70, 115) digitalisiert wird,
wobei ein zweites Signal (112) mit einem zweiten Zwischenfrequenzsignal (118) gemischt und das resultierende Signal (114) zu einem zweiten Messsignal (20, 51, 70, 116) digitalisiert wird, wobei die Frequenz des ersten Zwischenfrequenzsignals unterschiedlich zur Frequenz des zweiten Zwischenfrequenzsignals ist,
wobei zumindest das erste Messsignal (10, 50, 70, 115) und/oder das zweite Messsignal (20, 51, 70, 116) in seinem Spektrum derart verschoben werden, dass die Spektren des ersten Messsignals (10, 50, 70, 115) und des zweiten Messsignals (20, 51, 70, 116) eine gemeinsame Mittenfrequenz aufweisen, und
wobei das erste Messsignal (10, 50, 70, 115) und das zweite Messsignal (20, 51, 70, 116) unter Entfernung von Störsignalanteilen im ersten Messsignal (10, 50, 70, 115) bzw. im zweiten Messsignal (20, 51, 70, 116), die einen Schwellwert (74; 75) übersteigen, zu einem Gesamtmesssignal (40, 52, 108) kombiniert werden,
**dadurch gekennzeichnet,**
**dass** der Schwellwert (74; 75) einen 95%-99% Quantil von im ersten Messsignal (10, 50, 70, 115) bzw. im zweiten Messsignal (20, 51, 70, 116) jeweils enthaltenen Rauschwerten aufweist.

2. Verfahren nach Anspruch 1,
**dadurch gekennzeichnet,**
**dass** zur Entfernung der Störsignalanteile (30, 32, 33, 36, 53, 55, 56, 58) im ersten Messsignal (10, 50, 70, 115) bzw. im zweiten Messsignal (20, 51, 70, 116), die einen Schwellwert (75) übersteigen, die folgenden Schritte durchgeführt werden:
- Detektion von Störsignalanteilen (30, 32, 33, 36, 53, 55, 56, 58) im ersten Messsignal (10, 50, 70, 115) bzw. im zweiten Messsignal (20, 51, 70, 116), die einen Schwellwert (75) übersteigen;
- außerhalb der Störsignalanteilen (30, 32, 33, 36, 53, 55, 56, 58) im ersten Messsignal (10, 50, 70, 115) bzw. im zweiten Messsignal (20, 51, 70, 116), die einen Schwellwert (75) übersteigen:
Kombination des ersten Messsignals (10, 50, 70, 115) und des zweiten Messsignals (20, 51, 70, 116) zu dem Gesamtmesssignal (40, 52, 108);
- in den Störsignalanteilen (30, 32, 33, 36, 53, 55, 56, 58) im ersten Messsignal (10, 50, 70, 115) bzw. im zweiten Messsignal (20, 51, 70, 116), die einen Schwellwert (75) übersteigen:
Bildung des Gesamtmesssignals (40, 52, 108) durch das Messsignal (10, 20, 50, 51, 70, 115, 116), welches keinen Störsignalanteilen (30, 32, 33, 36, 53, 55, 56, 58) im ersten Messsignal (10, 50, 70, 115) bzw. im zweiten Messsignal (20, 51, 70, 116), die einen Schwellwert (75) übersteigen, aufweist.

3. Verfahren nach Anspruch 2,
**dadurch gekennzeichnet,**
**dass** zur Kombination des ersten Messsignals (10, 50, 70, 115) und des zweiten Messsignals (20, 51, 70, 116) zu dem Gesamtmesssignal (40, 52, 108) das Minimum oder der mittlere Pegel oder die mittlere Leistung der Messsignale (10, 20, 50, 51, 70, 115, 116) herangezogen wird.

4. Verfahren nach Anspruch 2 oder 3,
**dadurch gekennzeichnet,**
**dass** ein Störsignalanteil im ersten Messsignal (10, 50, 70, 115) bzw. im zweiten Messsignal (20, 51, 70, 116), der einen Schwellwert (75) übersteigt, detektiert wird, wenn entweder in dem ersten Messsignal (10, 50, 70, 115) oder dem zweiten Messsignal (20, 51, 70, 116) ein Signalanteil (11, 12, 13, 14, 15, 21, 22, 23, 24, 25, 30, 31, 23, 33, 34, 35, 36, 41, 42, 43, 53, 54, 55, 56, 57, 58, 71, 72, 73), der einen Schwellwert (75) übersteigt, vorliegt.

5. Verfahren nach einem der Ansprüche 1 bis 4,
**dadurch gekennzeichnet,**
**dass** Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73) des ersten Messsignals (10, 50, 70, 115) und des zweiten Messsignals (20, 51, 70, 116), die einen Schwellwert (75) übersteigen, bestimmt werden, und
**dass** zur Bestimmung der Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73), die einen Schwellwert (75) übersteigen, das erste Messsignal (10, 50, 70, 115) und das zweite Messsignal (20, 51, 70, 116) mit jeweils einer Schwellwertkurve (75) verglichen werden.

6. Verfahren nach Anspruch 5,
**dadurch gekennzeichnet,**
**dass** die Schwellwertkurven (75) derart gewählt werden, dass höchstens 5%, vorzugsweise höchstens 1% der Werte des jeweiligen Messsignals (10, 20, 50, 51, 70, 115, 116) die Schwellwertkurve (75) übersteigen.

7. Verfahren nach Anspruch 5 oder 6,
**dadurch gekennzeichnet,**
**dass** zur Bestimmung der Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73), die einen Schwellwert (75) übersteigen, die folgenden Schritte durchgeführt werden:
- Suche nach einem ersten Überschreiten der Schwellwertkurve (75);
- Suche von dem ersten Überschreiten der Schwellwertkurve (75) nach dem letzten Unterschreiten der Schwellwertkurve (74), die einen bestimmten Quantil von im ersten Messsignal (10, 50, 70, 115) bzw. im zweiten Messsignal (20, 51, 70, 116) jeweils enthaltenen Rauschwerten aufweist, und
- Suche von dem ersten Überschreiten der Schwellwertkurve (75) nach dem ersten Unterschreiten der Schwellwertkurve (74), die einen bestimmten Quantil von im ersten Messsignal (10, 50, 70, 115) bzw. im zweiten Messsignal (20, 51, 70, 116) jeweils enthaltenen Rauschwerten aufweist.

8. Verfahren nach einem der Ansprüche 1 bis 7,
**dadurch gekennzeichnet,**
**dass** das erste Signal (111) und das zweite Signal (112) jeweils durch Beaufschlagung eines Messobjekts (101) mit einem identischen Anregungssignal (120), welches einen Frequenzverlauf beinhaltet, erzeugt werden.

9. Messgerät zur Unterdrückung eines Störsignals, mit einem Mischer (102), einem Analog-Digital-Wandler (104) und einer Ersetzungseinrichtung (107),
wobei der Mischer (102) dazu ausgebildet ist, ein erstes Signal (111) mit einem ersten Zwischenfrequenzsignal (117) zu mischen und ein zweites Signal (112) mit einer zweiten Zwischenfrequenzsignal (118) zu mischen, wobei die Frequenz des ersten Zwischenfrequenzsignals unterschiedlich zur Frequenz des zweiten Zwischenfrequenzsignals ist,
wobei der Analog-Digital-Wandler (104) dazu ausgebildet ist, das mit der ersten Zwischenfrequenzsignal (117) gemischte erste Signal (111) zu einem ersten Messsignal (10, 50, 70, 115) zu digitalisieren und das mit der zweiten Zwischenfrequenzsignal (118) gemischte zweite Signal (112) zu einem zweiten Messsignal (20, 51, 70, 116) zu digitalisieren, und
wobei die Ersetzungseinrichtung (107) dazu ausgebildet ist, das erste Messsignal (10, 50, 70, 115) und das zweite Messsignal (20, 51, 70, 116) unter Entfernung von Störsignalanteilen (30, 32, 33, 36, 53, 55, 56, 58) im ersten Messsignal (10, 50, 70, 115) bzw. im zweiten Messsignal (20, 51, 70, 116), die einen Schwellwert (75) übersteigen, zu einem Gesamtmesssignal (40, 52, 108) zu kombinieren,
**dadurch gekennzeichnet,**
**dass** der Schwellwert (74; 75) einen 95%-99% Quantil von im ersten Messsignal (10, 50, 70, 115) bzw. im zweiten Messsignal (20, 51, 70, 116) jeweils enthaltenen Rauschwerten enthält.

10. Messgerät nach Anspruch 9,
**dadurch gekennzeichnet,**
**dass** eine Normierungseinrichtung (105) vorhanden ist,
wobei die Normierungseinrichtung (105) ausgebildet ist, um zumindest das erste Messsignal (10, 50, 70, 115) und das zweite Messsignal (20, 51, 70, 116) in seinem Spektrum derart zu verschieben, dass die Spektren des ersten Messsignals (10, 50, 70, 115) und des zweiten Messsignals (20, 51, 70, 116 eine gemeinsame Mittenfrequenz aufweisen.

11. Messgerät nach Anspruch 9 oder 10,
**dadurch gekennzeichnet,**
**dass** das Messgerät weiterhin einen Spitzenwert-Detektor (106) beinhaltet,
**dass** der Spitzenwert-Detektor (106) ausgebildet ist, um Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73) der Messsignale (10, 20, 50, 51, 70, 115, 116), die einen Schwellwert (75) übersteigen, zu detektieren, und
**dass** die Ersetzungseinrichtung (107) ausgebildet ist, um Störsignalanteile (30, 32, 33, 36, 53, 55, 56, 58) im ersten Messsignal (10, 50, 70, 115) bzw. im zweiten Messsignal (20, 51, 70, 116), die einen Schwellwert (75) übersteigen, zu detektieren, um außerhalb der Störsignalanteile im ersten Messsignal (10, 50, 70, 115) bzw. im zweiten Messsignal (20, 51, 70, 116), die einen Schwellwert (75) übersteigen, das
erste Messsignal (10, 50, 70, 115) und das zweite Messsignal (20, 51, 70, 116) zu dem Gesamtmesssignal (40, 52, 108) zu kombinieren, und um in den Störsignalanteilen im ersten Messsignal (10, 50, 70, 115) bzw. im zweiten Messsignal (20, 51, 70, 116)), die einen Schwellwert (75) übersteigen, das Gesamtmesssignal (40, 52, 108) durch das Messsignal (10, 20, 50, 51, 70, 115, 116), welches keinen Störsignalanteil im ersten Messsignal (10, 50, 70, 115) bzw. im zweiten Messsignal (20, 51, 70, 116)), der einen Schwellwert (75) übersteigt, aufweist zu bilden.

12. Messgerät nach einem der Ansprüche 9 bis 11,
**dadurch gekennzeichnet,**
**dass** die Ersetzungseinrichtung (107) ausgebildet ist, um das erste Messsignal (10, 50, 70, 115) und das zweite Messsignal (40, 52, 108) durch Heranziehen des Minimums oder des mittleren Pegels oder der mittleren Leistung der Messsignale (10, 20, 50, 51, 70, 115, 116) zu dem Gesamtmesssignal zu kombinieren.

13. Messgerät nach einem der Ansprüche 9 bis 12,
**dadurch gekennzeichnet,**
**dass** die Ersetzungseinrichtung (107) ausgebildet ist, um einen Störsignalanteil im ersten Messsignal (10, 50, 70, 115) bzw. im zweiten Messsignal (20, 51, 70, 116)), der einen Schwellwert (75) übersteigt, zu detektieren, wenn in entweder dem ersten Messsignal (10, 50, 70, 115) oder dem zweiten Messsignal (20, 51, 70, 116) Signalanteile(11, 12, 13, 14, 15, 21, 22, 23, 24, 25, 30, 31, 23, 33, 34, 35, 36, 41, 42, 43, 53, 54, 55, 56, 57, 58, 71, 72, 73), die einen Schwellwert (75) übersteigen, vorliegt.

14. Messgerät nach einem der Ansprüche 10 bis 13,
**dadurch gekennzeichnet,**
**dass** das Messgerät weiterhin einen Spitzenwert-Detektor (106) beinhaltet, um Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73) des ersten Messsignals (10, 50, 70, 115) und des zweiten Messsignals (20, 51, 70, 116), die einen Schwellwert (75) übersteigen, zu bestimmen, und
**dass** der Spitzenwert-Detektor (106) ausgebildet ist, um zur Bestimmung der Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73) das erste Messsignal (10, 50, 70, 115) und das zweite Messsignal (20, 51, 70, 116), die einen Schwellwert (75) übersteigen, mit jeweils einer Schwellwertkurve (75) zu vergleichen.

15. Messgerät nach Anspruch 14,
**dadurch gekennzeichnet,**
**dass** der Spitzenwert-Detektor (106) ausgebildet, um die Schwellwertkurven (75) derart zu wählen, dass höchstens 5%, vorzugsweise höchstens 1% der Werte des jeweiligen Messsignals (10, 20, 50, 51, 70, 115, 116) die Schwellwertkurve (75) übersteigen.

16. Messgerät nach Anspruch 14 oder 15,
**dadurch gekennzeichnet,**
**dass** der Spitzenwert-Detektor (106) ausgebildet ist, um zur Bestimmung der Signalanteile (11, 12, 13, 14, 15, 21, 22, 23, 24, 25, 30, 31, 23, 33, 34, 35, 36, 41, 42, 43, 53, 54, 55, 56, 57, 58, 71, 72, 73), die einen Schwellwert (75) übersteigen, die folgenden Schritte durchzuführen:
- Suche nach einem ersten Überschreiten der Schwellwertkurve (75);
- Suche von dem ersten Überschreiten der Schwellwertkurve (75) nach dem letzten Unterschreiten der Schwellwertkurve (74), die einen bestimmten Quantil von im ersten Messsignal (10, 50, 70, 115) bzw. im zweiten Messsignal (20, 51, 70, 116) jeweils enthaltenen Rauschwerten aufweist, und
- Suche von dem ersten Überschreiten der Schwellwertkurve (75) nach dem ersten Unterschreiten der Schwellwertkurve (74), die einen bestimmten Quantil von im ersten Messsignal (10, 50, 70, 115) bzw. im zweiten Messsignal (20, 51, 70, 116) jeweils enthaltenen Rauschwerten aufweist.

17. Messgerät nach einem der Ansprüche 9 bis 16,
**dadurch gekennzeichnet,**
**dass** das Messgerät weiterhin eine Anregungseinrichtung (100) zur Beaufschlagung des Messobjekts (101) mit einem Anregungssignal (120) beinhaltet,
**dass** das Anregungssignal (120) einen Frequenzverlauf hat, und
**dass** das Anregungssignal (120) bei der Bestimmung des ersten Signals (111) und des zweiten Signals (112) identisch ist.

## Claims

1. A method for suppressing an interfering signal, wherein a first signal (111) is mixed with a first intermediate-frequency signal (117), and the resulting signal (113) is digitised to form a first measurement signal (10, 50, 70, 115),
wherein a second signal (112) is mixed with a second intermediate-frequency signal (118), and the resulting signal (114) is digitised to form a second measurement signal (20, 51, 70, 116), wherein the frequency of the first intermediate-frequency signal is different from the frequency of the second intermediate-frequency signal,
wherein at least the first measurement signal (10, 50, 70, 115) and/or the second measurement signal (20, 51, 70, 116) is displaced within its spectrum in such a manner that the spectra of the first measurement signal (10, 50, 70, 115) and of the second measurement signal (20, 51, 71, 116) comprise a common mid-frequency, and
wherein the first measurement signal (10, 50, 70, 115) and the second measurement signal (20, 51, 70, 116) are combined to form a combined measurement signal (40, 52, 108) with the removal of interfering-signal components in the first measurement signal (10, 50, 70, 115) and respectively in the second measurement signal (20, 51, 70, 116) which exceed a threshold value (74; 75),
**characterised in that**
the threshold value (74; 75) comprises a 95%-99% quantile of noise values contained in each case in the first measurement signal (10, 50, 70, 115) and respectively in the second measurement signal (20, 51, 70, 116).

2. The method according to claim 1,
**characterised in that**
for the removal of the interfering-signal components (30, 32, 33, 36, 53, 55, 56, 58) in the first measurement signal (10, 50, 70, 115) and respectively in the second measurement signal (20, 51, 70, 116) which exceed a threshold value (75), the following steps are implemented:
- detection of interfering-signal components (30, 32, 33, 36, 53, 55, 56, 58) in the first measurement signal (10, 50, 70, 115) and respectively in the second measurement signal (20, 51, 70, 116) which exceed a threshold value (75) ;
- outside of the interfering-signal components (30, 32, 33, 36, 53, 55, 56, 58) in the first measurement signal (10, 50, 70, 115) and respectively in the second measurement signal (20, 51, 70, 116) which exceed a threshold value (75):
combination of the first measurement signal (10, 50, 70, 115) and of the second measurement signal (20, 51, 70, 116) to form the combined measurement signal (40, 52, 108) ;
- within the interfering-signal components (30, 32, 33, 36, 53, 55, 56, 58) in the first measurement signal (10, 50, 70, 115) and respectively in the second measurement signal (20, 51, 70, 116) which exceed a threshold value (75) :
formation of the combined measurement signal (40, 52, 108) through the measurement signal (10, 20, 50, 51, 70, 115, 116) which comprises no interfering-signal component (30, 32, 33, 36, 53, 55, 56, 58) in the first measurement signal (10, 50, 70, 115) and respectively in the second measurement signal (20, 51, 70, 116) which exceeds a threshold value (75).

3. The method according to claim 2,
**characterised in that,**
for the combination of the first measurement signal (10, 50, 70, 115) and the second measurement signal (20, 51, 70, 116) to form the combined measurement signal (40, 52, 108), the minimum or the mean level or the mean power of the measurement signals (10, 20, 50, 51, 70, 115, 116) is used.

4. The method according to claim 2 or 3,
**characterised in that**
an interfering-signal component in the first measurement signal (10, 50, 70, 115) or respectively in the second measurement signal (20, 51, 70, 116) which exceeds a threshold value (75) is detected, if, either in the first measurement signal (10, 50, 70, 115) or the second measurement signal (20, 51, 70, 116), a signal component (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceeds a threshold value (75) is present.

5. The method according to any one of claims 1 to 4,
**characterised in that**
the signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) of the first measurement signal (10, 50, 70, 115) and of the second measurement signal (20, 51, 70, 116) which exceed a threshold value (75) are determined, and
that, for the determination of the signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceed a threshold value (75), the first measurement signal (10, 50, 70, 115) and the second measurement signal (20, 51, 70, 116) are each compared with a threshold-value curve (75).

6. The method according to claim 5,
**characterised in that**
the threshold value curves (75) are selected in such a manner that at most 5%, preferably at most 1% of the values of the respective measurement signal (10, 20, 50, 51, 70, 115, 116) exceed the threshold-value curve (75).

7. The method according to claim 5 or 6,
**characterised in that,**
for the determination of the signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceed a threshold value (75), the following steps are implemented:
- search for a first overshooting of the threshold-value curve (75);
- search from the first overshooting of the threshold-value curve (75) for the last undercutting of the threshold-value curve (74) which comprises a given quantile of noise values contained in each case in the first measurement signal (10, 50, 70, 115) and respectively in the second measurement signal (20, 51, 70, 116), and
- search from the first overshooting of the threshold-value curve (75) for the first undercutting of the threshold-value curve (74) which comprises a given quantile of noise values contained in each case in the first measurement signal (10, 50, 70, 115) and respectively in the second measurement signal (20, 51, 70, 116).

8. The method according to any one of claims 1 to 7,
**characterised in that**
the first signal (111) and the second signal (112) are each generated by supplying a device under test (101) with an identical excitation signal (120) which contains a frequency response.

9. A measuring device for the suppression of an interfering signal, with a mixer (102), an analog-to-digital converter (104) and a substitution device (107),
wherein the mixer (102) is embodied to mix a first signal (111) with a first intermediate-frequency signal (117) and to mix a second signal (112) with a second intermediate-frequency signal (118), wherein the frequency of the first intermediate-frequency signal is different from the frequency of the second intermediate-frequency signal,
wherein the analog-to-digital converter (104) is embodied to digitise the first signal (111) mixed with the first intermediate-frequency signal (117) to form a first measurement signal (10, 50, 70, 115) and to digitise the second signal (112) mixed with the second intermediate-frequency signal (111) to form a second measurement signal (20, 51, 70, 116), and
wherein the substitution device (107) is embodied to combine the first measurement signal (10, 50, 70, 115) and the second measurement signal (20, 51, 70, 116), with the removal of interfering-signal components (30, 32, 33, 36, 53, 55, 56, 58) in the first measurement signal (10, 50, 70, 115) and respectively in the second measurement signal (20, 51, 70, 116) which exceed a threshold value (75), to form a combined measurement signal (40, 52, 108),
**characterised in that**
the threshold value (74; 75) contains a 95%-99% quantile of noise values contained in each case in the first measurement signal (10, 50, 70, 115) and respectively in the second measurement signal (20, 51, 70, 116).

10. The measuring device according to claim 9,
**characterised in that**
a standardisation device (105) is present,
wherein the standardisation device (105) is embodied to displace the first measurement signal (10, 50, 70, 115) and the second measurement signal (20, 51, 70, 116) in its spectrum in such a manner that the spectra of the first measurement signal (10, 50, 70, 115) and of the second measurement signal (20, 51, 70, 116) comprise a common mid-frequency.

11. The measuring device according to claim 9 or 10,
**characterised in that**
the measuring device further contains a peak detector (106), that the peak detector (106) is embodied to detect signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) of the measurement signals (10, 20, 50, 51, 70, 115, 116) which exceed a threshold value, and
that the substitution device (107) is embodied to detect interfering-signal components (30, 32, 33, 36, 53, 55, 56, 58) in the first measurement signal (10, 50, 70, 115) and respectively in the second measurement signal (20, 51, 70, 116) which exceed a threshold value (75), in order, outside of the interfering-signal components in the first measurement signal (10, 50, 70, 115) and respectively in the second measurement signal (20, 51, 70, 116) which exceed a threshold value (75), to combine the first measurement signal (10, 50, 70, 115) and the second measurement signal (20, 51, 70, 116) to form the combined measurement signal (40, 52, 108), and, in order, within the interfering-signal components in the first measurement signal (10, 50, 70, 115) and respectively in the second measurement signal (20, 51, 70, 116) which exceed a threshold value (75), to form the combined measurement signal (40, 52, 108) through the measurement signal (10, 20, 50, 51, 70, 115, 116) which contains no interfering-signal component in the first measurement signal (10, 50, 70, 115) or respectively in the second measurement signal (20, 51, 70, 116) which exceeds a threshold value (75) .

12. The measuring device according to any one of claims 9 to 11,
**characterised in that**
the substitution device (107) is embodied to combine the first measurement signal (10, 50, 70, 115) and the second measurement signal (40, 52, 108) through use of the minimum or the mean level or the mean power of the measurement signals (10, 20, 50, 51, 70, 115, 116) to form the combined measurement signal.

13. The measuring device according to any one of claims 9 to 12,
**characterised in that**
the substitution device (107) is embodied to detect an interfering-signal component in the first measurement signal (10, 50, 70, 115) or respectively in the second measurement signal (20, 51, 70, 116) which exceeds a threshold value (75), whenever signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceed a threshold value (75) is present in either the first measurement signal (10, 50, 70, 115) or the second measurement signal (20, 51, 70, 116) .

14. The measuring device according to any one of claims 10 to 13,
**characterised in that**
the measuring device further contains a peak detector (106) to determine signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) of the first measurement signal (10, 50, 70, 115) and of the second measurement signal (20, 51, 70, 116) which exceed a threshold value (75), and
that, for the determination of the signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceed a threshold value (75), the peak detector (106) is embodied to compare the first measurement signal (10, 50, 70, 115) and the second measurement signal (20, 51, 70, 116) in each case with a threshold-value curve (75).

15. The measuring device according to claim 14,
**characterised in that**
the peak detector (106) is embodied to select the threshold-value curves (75) in such a manner that at most 5%, preferably at most 1% of the values of the respective measurement signal (10, 20, 50, 51, 70, 115, 116) exceed the threshold-value curve (75).

16. The measuring device according to claim 14 or 15,
**characterised in that,**
for the determination of the signal components (11, 12, 13, 14, 15, 21, 22, 23, 24, 25, 30, 31, 23, 33, 34, 35, 36, 41, 42, 43, 53, 54, 55, 56, 57, 58, 71, 72, 73) which exceed a threshold value (75), the peak detector (106) is embodied to implement the following steps:
- search for a first overshooting of the threshold-value curve (75);
- search from the first overshooting of the threshold-value curve (75) for the last undercutting of the threshold-value curve (74) which comprises a given quantile of noise values contained in each case in the first measurement signal (10, 50, 70, 115) and respectively in the second measurement signal (20, 51, 70, 116), and
- search from the first overshooting of the threshold-value curve (75) for the first undercutting of the threshold-value curve (74) which comprises a given quantile of noise values contained in each case in the first measurement signal (10, 50, 70, 115) and respectively in the second measurement signal (20, 51, 70, 116).

17. The measuring device according to any one of claims 9 to 16,
**characterised in that**
the measuring device further contains an excitation device (100) for supplying the device under test (101) with an excitation signal (120),
that the excitation signal (120) has a frequency response, and
that, in the determination of the first signal (111) and of the second signal (112), the excitation signal (120) is identical.

## Revendications

1. Procédé de suppression d'un signal brouilleur, dans lequel un premier signal (111) est mélangé avec un premier signal de fréquence intermédiaire (117) et le signal résultant (113) est numérisé pour former un premier signal de mesure (10, 50, 70, 115),
dans lequel un second signal (112) est mélangé avec un second signal de fréquence intermédiaire (118) et le signal résultant (114) est numérisé pour former un second signal de mesure (20, 51, 70, 116), dans lequel la fréquence du premier signal de fréquence intermédiaire est différente de la fréquence du second signal de fréquence intermédiaire,
dans lequel au moins le premier signal de mesure (10, 50, 70, 115) et/ou le second signal de mesure (20, 51, 70, 116) est déplacé à l'intérieur de son spectre, de telle sorte que les spectres du premier signal de mesure (10, 50, 70, 115) et du second signal de mesure (20, 51, 70, 116) comportent une fréquence centrale commune, et
dans lequel le premier signal de mesure (10, 50, 70, 115) et le second signal de mesure (20, 51, 70, 116) sont combinés pour former un signal de mesure global (40, 52, 108) en éliminant des composantes de signal brouilleur dans le premier signal de mesure (10, 50, 70, 115) ou dans le second signal de mesure (20, 51, 70, 116) qui dépassent une valeur de seuil (74 ; 75),
**caractérisé en ce que**
la valeur de seuil (74 ; 75) comporte un quantile de 95 % à 99 % de valeurs de bruit respectivement contenues dans le premier signal de mesure (10, 50, 70, 115) ou dans le second signal de mesure (20, 51, 70, 116).

2. Procédé selon la revendication 1,
**caractérisé en ce que**
pour l'élimination des composantes de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75), les étapes suivantes sont réalisées :
- détection de composantes de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75) ;
- à l'extérieur des composantes de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75) : combinaison du premier signal de mesure (10, 50, 70, 115) et du second signal de mesure (20, 51, 70, 116) pour former le signal de mesure global (40, 52, 108) ;
- à l'intérieur des composantes de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75) : formation du signal de mesure global (40, 52, 108) au moyen du signal de mesure (10, 20, 50, 51, 70, 115, 116) qui ne comporte aucune composante de signal brouilleur (30, 32, 33, 36, 53, 55, 56, 58) dans le premier signal de mesure (10, 50, 70, 115) ou dans le second signal de mesure (20, 51, 70, 116) qui dépasse une valeur de seuil (75) .

3. Procédé selon la revendication 2,
**caractérisé en ce que**
pour la combinaison du premier signal de mesure (10, 50, 70, 115) et du second signal de mesure (20, 51, 70, 116) pour former le signal de mesure global (40, 52, 108), le minimum ou le niveau moyen ou la puissance moyenne des signaux de mesure (10, 20, 50, 51, 70, 115, 116) est utilisé.

4. Procédé selon la revendication 2 ou 3,
**caractérisé en ce que**
une composante de signal brouilleur dans le premier signal de mesure (10, 50, 70, 115) ou dans le second signal de mesure (20, 51, 70, 116) qui dépasse une valeur de seuil (75) est détectée lorsqu'une composante de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) qui dépasse une valeur de seuil (75) est présente soit dans le premier signal de mesure (10, 50, 70, 115), soit dans le second signal de mesure (20, 51, 70, 116).

5. Procédé selon l'une des revendications 1 à 4, **caractérisé en ce que**
des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) du premier signal de mesure (10, 50, 70, 115) et du second signal de mesure (20, 51, 70, 116) qui dépassent une valeur de seuil (75), sont déterminées, et
pour la détermination des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) qui dépassent une valeur de seuil (75), le premier signal de mesure (10, 50, 70, 115) et le second signal de mesure (20, 51, 70, 116) sont chacun comparés à une courbe de valeurs de seuil (75).

6. Procédé selon la revendication 5,
**caractérisé en ce que**
les courbes de valeurs de seuil (75) sont sélectionnées de telle sorte qu'au plus 5 %, de préférence au plus 1 %, des valeurs du signal de mesure (10, 20, 50, 51, 70, 115, 116) respectif dépassent la courbe de valeurs de seuil (75).

7. Procédé selon la revendication 5 ou 6,
**caractérisé en ce que**
pour la détermination des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) qui dépassent une valeur de seuil (75), les étapes suivantes sont réalisées :
- recherche d'un premier passage au-dessus de la courbe de valeurs de seuil (75) ;
- recherche, en partant du premier passage au-dessus de la courbe de valeurs de seuil (75), du dernier passage en dessous de la courbe de valeurs de seuil (74) qui comporte un quantile déterminé de valeurs de bruit respectivement contenues dans le premier signal de mesure (10, 50, 70, 115) ou dans le second signal de mesure (20, 51, 70, 116), et
- recherche, en partant du premier passage au-dessus de la courbe de valeurs de seuil (75), du premier passage en dessous de la courbe de valeurs de seuil (74) qui comporte un quantile déterminé de valeurs de bruit respectivement contenues dans le premier signal de mesure (10, 50, 70, 115) ou dans le second signal de mesure (20, 51, 70, 116).

8. Procédé selon l'une des revendications 1 à 7,
**caractérisé en ce que**
le premier signal (111) et le second signal (112) sont chacun générés en appliquant à un objet de mesure (101) un signal d'excitation identique (120) qui contient une réponse en fréquence.

9. Appareil de mesure pour la suppression d'un signal brouilleur, avec un mélangeur (102), un convertisseur analogique-numérique (104) et un dispositif de substitution (107),
dans lequel le mélangeur (102) est mis en œuvre de manière à mélanger un premier signal (111) avec un premier signal de fréquence intermédiaire (117) et pour mélanger un second signal (112) avec un second signal de fréquence intermédiaire (118), dans lequel la fréquence du premier signal de fréquence intermédiaire est différente de la fréquence du second signal de fréquence intermédiaire,
dans lequel le convertisseur analogique-numérique (104) est mis en œuvre de manière à numériser le premier signal (111) mélangé avec le premier signal de fréquence intermédiaire (117) pour former un premier signal de mesure (10, 50, 70, 115) et à numériser le second signal (112) mélangé avec le second signal de fréquence intermédiaire (118) pour former un second signal de mesure (20, 51, 70, 116), et
dans lequel le dispositif de substitution (107) est mis en œuvre de manière à combiner le premier signal de mesure (10, 50, 70, 115) et le second signal de mesure (20, 51, 70, 116) en éliminant des composants de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75), pour former un signal de mesure global (40, 52, 108),
**caractérisé en ce que**
la valeur de seuil (74 ; 75) contient un quantile de 95 % à 99 % de valeurs de bruit respectivement contenues dans le premier signal de mesure (10, 50, 70, 115) ou dans le second signal de mesure (20, 51, 70, 116).

10. Appareil de mesure selon la revendication 9,
**caractérisé en ce que**
un dispositif de normalisation (105) est présent,
dans lequel le dispositif de normalisation (105) est mis en œuvre de manière à déplacer au moins le premier signal de mesure (10, 50, 70, 115) et le second signal de mesure (20, 51, 70, 116) à l'intérieur de son spectre, de telle sorte que les spectres du premier signal de mesure (10, 50, 70, 115) et du second signal de mesure (20, 51, 70, 116) comportent une fréquence centrale commune.

11. Appareil de mesure selon la revendication 9 ou 10,
**caractérisé en ce que**
l'appareil de mesure contient en outre un détecteur de valeur de crête (106),
le détecteur de valeur de crête (106) est mis en œuvre de manière à détecter des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) des signaux de mesure (10, 20, 50, 51, 70, 115, 116) qui dépassent une valeur de seuil (75), et
le dispositif de substitution (107) est mis en œuvre de manière à détecter des composants de signal brouilleur (30, 32, 33, 36, 53, 55, 56, 58) dans le premier signal de mesure (10, 50, 70, 115) ou dans le second signal de mesure (20, 51, 70, 116) qui dépassent une valeur de seuil (75), afin de combiner, à l'extérieur des composantes de signal brouilleur dans le premier signal de mesure (10, 50, 70, 115) ou dans le second signal de mesure (20, 51, 70, 116) qui dépassent une valeur de seuil (75), le premier signal de mesure (10, 50, 70, 115) et le second signal de mesure (20, 51, 70, 116) pour former le signal de mesure global (40, 52, 108), et afin de former, à l'intérieur des composantes de signal brouilleur dans le premier signal de mesure (10, 50, 70, 115) ou dans le second signal de mesure (20, 51, 70, 116) qui dépassent une valeur de seuil (75), le signal de mesure global (40, 52, 108) au moyen du signal de mesure (10, 20, 50, 51, 70, 115, 116) qui ne comporte aucune composante de signal brouilleur dans le premier signal de mesure (10, 50, 70, 115) ou dans le second signal de mesure (20, 51, 70, 116) qui dépasse une valeur de seuil (75).

12. Appareil de mesure selon l'une des revendications 9 à 11,
**caractérisé en ce que**
le dispositif de substitution (107) est mis en œuvre de manière à combiner le premier signal de mesure (10, 50, 70, 115) et le second signal de mesure (40, 52, 108) pour former le signal de mesure global par l'utilisation du minimum ou du niveau moyen ou de la puissance moyenne des signaux de mesure (10, 20, 50, 51, 70, 115, 116).

13. Appareil de mesure selon l'une des revendications 9 à 12,
**caractérisé en ce que**
le dispositif de substitution (107) est mis en œuvre de manière à détecter une composante de signal brouilleur dans le premier signal de mesure (10, 50, 70, 115) ou dans le second signal de mesure (20, 51, 70, 116) qui dépasse une valeur de seuil (75), lorsque des composants de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) qui dépassent une valeur de seuil (75) sont présentes soit dans le premier signal de mesure (10, 50, 70, 115), soit dans le second signal de mesure (20, 51, 70, 116).

14. Appareil de mesure selon l'une des revendications 10 à 13,
**caractérisé en ce que**
l'appareil de mesure contient en outre un détecteur de valeur de crête (106) afin de déterminer des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) du premier signal de mesure (10, 50, 70, 115) et du second signal de mesure (20, 51, 70, 116) qui dépassent une valeur de seuil (75), et
pour la détermination des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73), le détecteur de valeur de crête (106) est mis en œuvre de manière à comparer respectivement le premier signal de mesure (10, 50, 70, 115) et le second signal de mesure (20, 51, 70, 116) qui dépassent une valeur de seuil (75), avec une courbe de valeurs de seuil (75).

15. Appareil de mesure selon la revendication 14,
**caractérisé en ce que**
le détecteur de valeur de crête (106) est mis en œuvre de manière à sélectionner les courbes de valeurs de seuil (75) de telle sorte qu'au plus 5 %, de préférence au plus 1 %, des valeurs du signal de mesure (10, 20, 50, 51, 70, 115, 116) respectif dépassent la courbe de valeurs de seuil (75).

16. Appareil de mesure selon la revendication 14 ou 15,
**caractérisé en ce que**
pour la détermination des composantes de signal (11, 12, 13, 14, 15, 21, 22, 23, 24, 25, 30, 31, 23, 33, 34, 35, 36, 41, 42, 43, 53, 54, 55, 56, 57, 58, 71, 72, 73) qui dépassent une valeur de seuil (75), le détecteur de valeur de crête (106) est mis en œuvre de manière à réaliser les étapes suivantes :
- recherche d'un premier passage au-dessus de la courbe de valeurs de seuil (75) ;
- recherche, en partant du premier passage au-dessus de la courbe de valeurs de seuil (75), du dernier passage en dessous de la courbe de valeurs de seuil (74) qui comporte un quantile déterminé de valeurs de bruit respectivement contenues dans le premier signal de mesure (10, 50, 70, 115) ou dans le second signal de mesure (20, 51, 70, 116), et
- recherche, en partant du premier passage au-dessus de la courbe de valeurs de seuil (75), du premier passage en dessous de la courbe de valeurs de seuil (74) qui comporte un quantile déterminé de valeurs de bruit respectivement contenues dans le premier signal de mesure (10, 50, 70, 115) ou dans le second signal de mesure (20, 51, 70, 116).

17. Appareil de mesure selon l'une des revendications 9 à 16,
**caractérisé en ce que**
l'appareil de mesure contient en outre un dispositif d'excitation (100) pour appliquer à l'objet de mesure (101) un signal d'excitation (120),
le signal d'excitation (120) a une réponse en fréquence, et
lors de la détermination du premier signal (111) et du second signal (112), le signal d'excitation (120) est identique.
